**Europäisches Patentamt**

**European Patent Office**

**Office européen des brevets**

(11) Veröffentlichungsnummer : **0 069 911**
**B1**

(12) **EUROPÄISCHE PATENTSCHRIFT**

(45) Veröffentlichungstag der Patentschrift :
07.05.86

(51) Int. Cl.⁴ : **B 41 N   3/08**, G 03 F   7/26

(21) Anmeldenummer : **82105719.7**

(22) Anmeldetag : **28.06.82**

(54) **Verfahren und Lösung zum Konservieren von Flachdruckformen.**

(30) Priorität : **13.07.81 DE 3127668**

(43) Veröffentlichungstag der Anmeldung :
**19.01.83 Patentblatt 83/03**

(45) Bekanntmachung des Hinweises auf die Patenterteilung : **07.05.86 Patentblatt 86/19**

(84) Benannte Vertragsstaaten :
**BE DE FR GB NL**

(56) Entgegenhaltungen :
**WO-A-79 /005 93**
**DE-A- 1 447 961**
**DE-B- 1 143 710**
**FR-A- 2 340 566**

(73) Patentinhaber : **HOECHST AKTIENGESELLSCHAFT**
**Postfach 80 03 20**
**D-6230 Frankfurt am Main 80 (DE)**

(72) Erfinder : **Berghäuser, Günter**
**Schönaustrasse 58**
**D-6200 Wiesbaden (DE)**
Erfinder : **Schell, Loni**
**Erbacher Strasse 10**
**D-6238 Hofheim-Wallau (DE)**
Erfinder : **Frass, Werner, Dr.**
**Erbsenacker 37**
**D-6200 Wiesbaden (DE)**

**Beschreibung**

Die Erfindung betrifft eine Lösung und ein Verfahren zum Konservieren von druckfertig entwickelten Flachdruckformen, um die Platten während der Lagerung vor der Verwendung zum Drucken gegen Luftzutritt und Verschmutzung zu schützen und zugleich ihre nichtdruckenden Oberflächenbereiche dauerhaft zu hydrophilieren.

Es ist bekannt, daß druckfertige Flachdruckplatten vor jeder längeren Lagerung einer derartigen schützenden Behandlung unterworfen werden müssen. Als Behandlungslösung wird dabei sehr verbreitet wäßrige Gummi arabicum-Lösung verwendet. Es ist auch bekannt, Dextrinlösungen einzusetzen.

In der DE-OS 26 59 754 wird die Verwendung von wäßrigen Polyvinylalkohollösungen für den gleichen Zweck beschrieben.

Aus der DE-OS 25 04 594 ist ferner die Kombination von Carboxylgruppen enthaltenden Acrylamidpolymerisaten mit Säuren, insbesondere Phosphorsäure, als Hydrophilierungsmittel und zur Konservierung von Druckformen bekannt.

Nach der Behandlung mit der Konservierungslösung werden die Platten zumeist einige Zeit, häufig auch am Licht, gelagert. Es zeigte sich bei negativ arbeitenden Druckplatten, besonders solchen auf Basis von Diazoniumsalz-Kondensationsprodukten als lichtempfindlichen Verbindungen, daß die Oleophilie, d. h. das Farbannahmevermögen der Bildstellen dieser Platten bei der Lagerung oft erheblich gemindert wird, so daß die Anzahl der unbrauchbaren Druckbogen am Anfang der Auflage sehr hoch ist. Diese Erscheinung ist besonders bei solchen Druckplatten zu beobachten, deren lichtempfindliche Schicht überwiegend oder vollständig aus Diazoniumverbindungen besteht.

Dieses Problem wird in der EP-OS 24 872 beschrieben. Dort wird zu seiner Beseitigung vorgeschlagen, der Konservierungslösung reaktive Stoffe, z. B. Azokuppler in saurer oder alkalischer Lösung oder Reduktionsmittel zuzusetzen. Diese Stoffe reagieren mit der noch vorhandenen unzerstörten Diazoniumverbindung und verhindern das Nachlassen der Oleophilie. Dieses Verfahren hat den Nachteil, daß die Haltbarkeit der Konservierungslösungen durch den Gehalt an sehr reaktionsfähigen Stoffen verringert wird. Auch bei längerer Lagerung der konservierten Platten können unerwünschte Reaktionen zwischen den reaktiven Bestandteilen der Konservierung und der Oberfläche des Schichtträgers eintreten, die dessen Hydrophilie beeinträchtigen. Auch wird dadurch, daß die reaktiven Stoffe zumeist in alkalischer Lösung angewendet werden, die Möglichkeit zum Zusatz von sauren Hydrophilierungsmitteln zur Konservierung sehr beschränkt.

Die DE-AS 11 43 710 beschreibt eine Lackemulsion zur Nachbehandlung entwickelter Flachdruckformen, bestehend aus einer wäßrigen Phase, die mindestens ein organisches wasserlösliches Kolloid und gegebenenfalls ein oder mehrere Netzmittel und/oder bakterizide Stoffe enthält, und einer nichtwäßrigen Phase, die mindestens ein organisches Lösungsmittel, mindestens ein Kondensationsprodukt von Phenolen mit Formaldehyd vom Novolak-Typ und gegebenenfalls einen oder mehrere organisch lösliche Farbstoffe und/oder Ultraviolett stark absorbierender Substanzen enthält.

Als in der organischen Phase lösliche UV absorbierende Substanzen werden hauptsächlich Benzophenone genannt.

Aufgabe der Erfindung ist es, eine Konservierungslösung zur Verfügung zu stellen, die das Nachlassen der Oleophilie der konservierten Druckplatten verhindert und die keine stark reaktiven Bestandteile enthält.

Gegenstand der Erfindung ist eine Lösung zum Konservieren von druckfertigen Flachdruckformen auf Basis von lichtgehärteten Diazoverbindungen, die eine wasserlösliche filmbildende hochmolekulare organische Verbindung und Wasser als Lösungsmittel enthält. Die erfindungsgemäße Lösung ist dadurch gekennzeichnet, daß sie ferner eine Verbindung enthält, die eine starke Lichtabsorption in dem Spektralbereich aufweist, in dem die Photolyse von lichtempfindlichen aromatischen Diazoverbindungen initiiert wird und die der Gruppe der wasserlöslichen Pyrazolinderivate 6-Phenyl-$\alpha$-pyronderivate, Chinolinderivate, substituierte Heterocyclen und 2,4-Dinitro-diphenylamin-carboxylate angehört.

Erfindungsgemäß wird ferner ein Verfahren zum Konservieren von druckfertigen Flachdruckformen auf Basis von lichtgehärteten Diazoverbindungen vorgeschlagen, bei dem die Flachdruckform mit einer wäßrigen Lösung einer wasserlöslichen filmbildenden hochmolekularen organischen Verbindung behandelt und dann getrocknet wird. Das Verfahren ist dadurch gekennzeichnet, daß man eine Lösung verwendet, die ferner eine Verbindung enthält, die eine starke Lichtabsorption in dem Spektralbereich aufweist, in dem die Photolyse von lichtempfindlichen aromatischen Diazoverbindungen initiiert wird und die der Gruppe der wasserlöslichen Pyrazolinderivate 6-Phenyl-$\alpha$-pyronderivate, Chinolinderivate, substituierte Heterocyclen und 2,4-Dinitro-diphenylamin-carboxylate angehört.

Durch die Erfindung wird erreicht, daß die mit der erfindungsgemäßen Lösung behandelten Druckformen auch nach Lagerung ihre Oleophilie in den Bildstellen und ihre Hydrophilie in den Hintergrundstellen im wesentlichen behalten und daß die Konservierungslösungen ihre Wirksamkeit auch nach längerer Lagerung beibehalten.

Die lichtabsorbierenden Verbindungen sollen eine starke Absorption im Anregungsbereich der in der lichtempfindlichen Schicht enthaltenen Diazoverbindungen aufweisen. Vorzugsweise liegt diese Absorption im Bereich von etwa 300 bis 450, insbesondere von 330 bis 420 nm.

2

Die Konzentration der lichtabsorbierenden Verbindungen in der Konservierungslösung kann in weiten Grenzen variieren. Sie liegt im allgemeinen zwischen 0,1 und 10, vorzugsweise zwischen 0,3 ur ' 3 Gew.-%.

Die Lösungen enthalten außer den lichtabsorbierenden Verbindungen in bekannter Weise wasserlösliche filmbildende organische Polymere. Hierfür sind grundsätzlich alle derartigen Substanzen geeignet, die üblicherweise als Bestandteile von Konservierungslösungen für Flachdruckformen verwendet werden. Geeignete Beispiele sind Gummi arabicum, Dextrine, Polyvinylalkohol und die eingangs erwähnten Acrylamidpolymerisate. Die Konzentration der hochmolekularen Verbindungen liegt allgemein zwischen 4 und 40, bevorzugt zwischen 5 und 35 Gew.-%.

Sie können ferner hydrophilierende Säuren, z. B. Phosphorsäure oder organische Phosphonsäuren, enthalten.

Auch kann es in bestimmten Fällen zweckmäßig sein, Biocide, Netzmittel oder Entschäumer oder kleine Mengen, d. h. wenige Prozent, mit Wasser mischbarer leicht flüchtiger organischer Lösungsmittel zuzusetzen.

Die Konservierungslösung kann auf die Plattenoberfläche durch Reiben oder Tamponieren mit der Hand, durch Tauchen in ein Bad oder in einer Verarbeitungsvorrichtung durch Walzen, Besprühen oder dgl. aufgebracht werden. Sie wird anschließend getrocknet.

Als Trägermaterialien der zu behandelnden Druckformen wird allgemein Aluminium verwendet. Dabei kommen insbesondere die bekannten und bevorzugt verwendeten Trägermaterialien mit veredelter Oberfläche in Betracht, z. B. mechanisch, chemisch oder elektrochemisch aufgerauhtes und ggf. mit Alkalisilikaten, polymeren Säuren oder anderen bekannten Mitteln behandeltes Aluminium. Insbesondere ist die Lösung zur Behandlung von Druckplatten mit Trägern aus anodisch oxidiertem Aluminium geeignet, wobei auch die Oxidschicht mit den vorstehend angegebenen Mitteln, z. B. Silikaten oder Polyvinylphosphonsäure, vorbehandelt sein kann.

Als lichtempfindliche Schichten werden solche auf der Basis von aromatischen Diazoniumsalz-Kondensationsprodukten oder p-Chinondiaziden verwendet. Geeignete Materialien dieser Art sind in den folgenden Druckschriften beschrieben: DE-PS 1 104 824, 1 134 093, 1 214 086, DE-OS 20 24 244, 20 34 655 und 27 39 774.

Die folgenden Beispiele erläutern bevorzugte Ausführungsformen der Erfindung. Die Gewichtsteile (Gt) sind in Gramm und die Volumenteile (Vt) in ml angegeben. Prozentangaben und Mengenverhältnisse sind auf Gewichtseinheiten bezogen, wenn nichts anderes angegeben ist.

## Beispiel 1

Eine durch Bürsten mechanisch aufgerauhte Aluminiumfolie wurde mit einer 0,1 %igen wäßrigen Lösung von Polyvinylphosphonsäure vorbehandelt und dann mit einer Lösung von

0,125 Gt des Rohkondensats aus Paraformaldehyd und Diphenylamin-4-diazoniumchlorid, hergestellt in 85 %iger Phosphorsäure (vgl. Beispiel 1 der DE-PS 12 14 086),

8 Gt Wasser und

40 Gt Dimethylformamid

beschichtet und getrocknet. Die erhaltene lichtempfindliche Druckplatte wurde unter einem 21-stufigen Halbton-Stufenkeil mit Dichteunterschieden von 0,15 je Stufe so belichtet, daß die Stufe 5 voll gedeckt war. Dann wurden die unbelichteten Schichtbereiche mit Wasser ausgewaschen und die Platte mit 1 %iger Phosphorsäure fixiert. Die Platte wurde trockengerieben und dann mit der folgenden Konservierungslösung überzogen und getrocknet:

10 Gt Tapiokadextrin,

1 Gt Glycerin,

0,3 Gt Natrium-2,4-Dinitro-diphenylamin-2'-carboxylat und

88 Gt Wasser.

Nach dieser Behandlung wurde die eine Hälfte der Platte 5 Minuten unter einer 5 kW-Xenonlampe ohne Vorlage nachbelichtet und die Platte in eine Kleinoffsetmaschine eingespannt und angedruckt. Bereits nach 15 Drucken war kein Unterschied mehr zwischen dem nachbelichteten Teil und dem Rest der Platte zu erkennen.

Eine Wiederholung des Beispiels mit der gleichen Konservierung ohne den Zusatz von UVabsorbierender Verbindung ergab eine geschwächte Farbannahme der nachbelichteten Bereiche bis zu 50 Drucken.

## Beispiel 2

Eine elektrolytisch aufgerauhte und anodisch oxidierte Aluminiumplatte mit einer Oxidschicht von 3 g/m², die mit einer 0,1 %igen Lösung von Polyvinylphosphonsäure nachbehandelt worden war, wurde mit einer Lösung von

1 Gt eines Diazoniumsalz-Polykondensationsprodukts, hergestellt durch Kondensieren von 1 Mol 3-Methoxy-diphenylamin-4-diazoniumsulfat mit 1 Mol 4,4'-Bis-methoxymethyl-diphenylether in 85 %iger Phosphorsäure bei 40 °C und isoliert als Mesitylensulfonat,

1,8 Gt eines nichtplastifizierten Harnstoffharzes mit einer Säurezahl unter 3, der dynamischen Viskosität in 65 %iger Lösung in Butanol/Xylol (1 : 1) bei 20 °C von 6 000 mPa·s und

0,4 Gt Kristallviolett in

96,8 Gt Ethylenglykolmonomethylether

beschichtet und getrocknet.

Die Platte wurde 5 Sekunden mit einer metallhalogeniddotierten Quecksilberdampflampe von 5 kW belichtet und mit einer Lösung von

6 Gt MgSO$_4$ × 7 H$_2$O,

20 Gt n-Propanol und

0,7 Gt eines Alkylphenol-polyglykolethers (ca. 8-10 Glykoleinheiten) in

73,3 Gt Wasser

entwickelt. Die Platte wurde dann mit einer Lösung von

30 Gt Dextrin,

3 Gt Glycerin,

0,1 Gt Phosphorsäure (85 %) und

3 Gt des Triethanolammoniumsalzes der 2-Chlor-3-methyl-2-pyron-6-(phenyl-4-sulfonsäure) in

63,9 Gt Wasser

konserviert. Die Druckplatte wurde wie in Beispiel 1 beschrieben zur Hälfte nachbelichtet und dann angedruckt. Zwischen den nachbelichteten und nicht nachbelichteten Schichtbereichen zeigte sich nur ein geringer Unterschied in der Farbannahme.

Beispiel 3

Auf eine elektrolytisch aufgerauhte und anodisch oxydierte Aluminiumplatte, die mit Polyvinylphosphonsäure nachbehandelt worden war, wurde die folgende Lösung aufgebracht :

1 Gt des in Beispiel 2 angegebenen Diazoniumsalz-Polykondensationsprodukts,

0,05 Gt Kristallviolett,

100 Vt Ethylenglykolmonomethylether.

Die Platte wurde unter einer Vorlage belichtet und mit einer Lösung von 5 % Natriumlaurylsulfat in Wasser entwickelt. Sie wurde dann mit einer Lösung von

10 Gt Tapiokadextrin,

1 Gt Glycerin,

0,4 Gt Phosphorsäure (85 %) und

1 Gt 1-[4-(Dimethylaminoethoxy-ethylsulfonyl)-phenyl]-3-(4-chlor-phenyl)-$\Delta_2$-pyrazolin in

87,6 Gt Wasser

konserviert. Die Platte wurde wie in Beispiel 1 nachbelichtet und angedruckt. Nach 6 Drucken war die Farbannahme der nachbelichteten und nicht nachbelichteten Schichtbereiche gleich gut. Ähnliche Ergebnisse wurden erhalten, wenn statt des oben angegebenen Pyrazolins die gleiche Menge 1-[4-(Methylaminoethylsulfonyl)-phenyl]-3-(4-chlor-phenyl)-$\Delta_2$-pyrazolin verwendet wurde.

Beispiel 4

Eine elektrolytisch aufgerauhte und anodisch oxydierte Aluminiumplatte, die mit Polyvinylphosphonsäure nachbehandelt worden war, wurde mit einer Lösung von

1 Gt des in Beispiel 2 angegebenen Diazoniumsalz-Polykondensationsprodukts,

3 Gt Polyvinylbutyral (69-71 % Vinylbutyral-, 1 % Vinylacetat- und 24-27 % Vinylalkoholeinheiten) und

0,3 Gt Phosphorsäure (85 %) in

75,7 Gt Ethylenglykolmonomethylether und

20,0 Gt Butylacetat

beschichtet und getrocknet. Die Platte wurde bildmäßig belichtet und mit einer Lösung von

4

1,5 Gt Polyacrylsäure,
1,5 Gt Essigsäure,
15   Gt Isopropanol,
20   Gt n-Propanol und
50   Gt Wasser

entwickelt. Die Platte wurde dann mit einer Lösung von

15   Gt Gummi arabicum und
0,5 Gt 5-Hydroxy-1-(4-sulfo-phenyl)-4-(4-sulfophenylazo)-pyrazol-3-carbonsäure-Trinatriumsalz in
84,5 Gt Wasser

konserviert. Es wurde wie in Beispiel 1 nachbelichtet und angedruckt. Nach wenigen Drucken war die Farbannahme der nachbelichteten und nicht nachbelichteten Stellen der Druckschablone gleich. Wenn eine gleiche Platte mit einer entsprechenden Konservierungslösung ohne den gelben Farbstoff behandelt wurde, waren mehr als 50 Drucke erforderlich, bis die Farbannahme der nachbelichteten und nicht nachbelichteten Schichtbereiche gleich war.

Beispiel 5

Auf einen Schichtträger aus mechanisch aufgerauhtem Aluminium wurde eine Lösung von

1,5 Gt    1-(4-Methyl-benzolsulfonylimino)-2-(2,5-dimethyl-phenylaminosulfonyl)-benzochinon-(1,4)-diazid-(4) und
0,5 Gt eines Umsetzungsprodukts aus Kresol-Formaldehyd-Novolak und Chloressigsäure in
100   Vt Ethylenglykolmonomethylether

aufgebracht und getrocknet. Die erhaltene Druckplatte wurde unter einer Vorlage belichtet und mit einer Lösung von

10   Gt Natriummetasilikat $\times$ 9 $H_2O$ und
0,3 Gt Strontiumhydroxid in
1 000   Vt Wasser

entwickelt. Die entwickelte Druckform wurde mit einer Lösung von

17 Gt Gummi arabicum und
2 Gt D,L-8-(4-Amino-1-methyl-butylamino)-6-methoxy-chinolin-diphosphat in
81 Gt Wasser

konserviert. Die Platte konnte längere Zeit dem Licht ausgesetzt werden, ohne daß die Farbannahme der Bildschablone gemindert wurde.

**Patentansprüche**

1. Lösung zum Konservieren von druckfertigen Flachdruckformen auf Basis von lichtgehärteten Diazoverbindungen, die eine wasserlösliche filmbildende hochmolekulare organische Verbindung und Wasser als Lösungsmittel enthält, dadurch gekennzeichnet, daß sie ferner eine Verbindung enthält, die eine starke Lichtabsorption in dem Spektralbereich aufweist, in dem die Photolyse von lichtempfindlichen aromatischen Diazoverbindungen initiiert wird und die der Gruppe der wasserlöslichen Pyrazo- linderivate 6-Phenyl-α-pyronderivate, Chinolinderivate, substituierte Heterocyclen und 2,4-Dinitro-diphenylamin-carboxylate angehört.

2. Konservierungslösung nach Anspruch 1, dadurch gekennzeichnet, daß die Lichtabsorption der zugesetzten Verbindung im Bereich von 300-450 nm liegt.

3. Konservierungslösung nach Anspruch 1, dadurch gekennzeichnet, daß sie 0,1 bis 10 Gew.-% der lichtabsorbierenden Verbindung enthält.

4. Konservierungslösung nach Anspruch 1, dadurch gekennzeichnet, daß sie zusätzlich eine hydrophilierende Säure enthält.

5. Konservierungslösung nach Anspruch 1, dadurch gekennzeichnet, daß sie als wasserlösliche filmbildende hochmolekulare organische Verbindung Gummi arabicum, Dextrin, Polyvinylalkohol oder ein wasserlösliches Acrylamidpolymerisat enthält.

6. Verfahren zum Konservieren von druckfertigen Flachdruckformen auf Basis von lichtgehärteten Diazoverbindungen, bei dem die Flachdruckform mit einer wäßrigen Lösung einer wasserlöslichen filmbildenden hochmolekularen organischen Verbindung behandelt und getrocknet wird, dadurch gekennzeichnet, daß man eine Lösung verwendet, die ferner eine Verbindung enthält, die eine starke Lichtabsorption in dem Spektralbereich aufweist, in dem die Photolyse von lichtempfindlichen aromatischen Diazoverbindungen initiiert wird und die der Gruppe der wasserlöslichen Pyrazolinderivate 6-Phenyl-α-pyronderivate, Chinolinderivate, substituierte Heterocyclen und 2,4-Dinitrodiphenylamin-carboxylate angehört.

## Claims

1. A solution for desensitizing lithographic printing forms based on light-hardened diazo compounds, which are ready for printing, said solution comprising a water-soluble, film-forming, high molecular-weight organic compound and water as the solvent, characterized in that the solution additionally comprises a compound which exhibits a high absorption of light in the spectral region where the photolysis of light-sensitive aromatic diazo compounds is initiated and which is selected from the group including water-soluble pyrazoline derivates, 6-phenyl-α-pyrone derivatives, quinoline derivatives, substituted heterocyclic compounds and 2,4-dinitro-diphenylamine carboxylates.

2. A desensitizing solution according to claim 1, wherein the added compound absorbs light in the region from 300 to 450 nm.

3. A desensitizing solution according to claim 1, which contains from 0.1 to 10 percent by weight of the light-absorbing compound.

4. A desensitizing solution according to claim 1, which additionally contains a hydrophilizing acid.

5. A desensitizing solution according to claim 1, which contains gum arabic, dextrin polyvinyl alcohol or a water-soluble acrylamide polymer as the water-soluble, film-forming high molecular-weight organic compound.

6. A process for desensitizing lithographic printing forms based on light-hardened diazo compounds, which are ready for printing, said process comprising treating a lithographic printing form with an aqueous solution of a water-soluble, film-forming, high molecular-weight organic compound and then drying the printing form, wherein a solution is used, which additionally contains a compound exhibiting a high absorption of light in the spectral region where the photolysis of light-sensitive aromatic diazo compounds is initiated and which is selected from the group including water-soluble pyrazoline derivatives, 6-phenyl-α-pyrone derivatives, quinoline derivatives, substituted heterocyclic compounds and 2,4-dinitro-diphenylamine carboxylates.

## Revendications

1. Solution pour la conversation de formes pour impression à plat, prêtes à l'emploi, à base de composés diazoïques durcis à la lumière, contenant un composé organique macromoléculaire filmogène, soluble dans l'eau, et d'eau comme solvant, solution caractérisée en ce qu'elle contient en outre un composé qui montre une forte absorption de la lumière dans le domaine spectral dans lequel la photolyse des composés diazoïques aromatiques, photosensibles, est initiée et qui appartient au groupe des dérivés de pyrazoline, des dérivés de 6-phényl-α-pyrone, des dérivés de quinoléine, des hétérocycles substitués et des 2,4-dinitro-diphénylamino-carboxylates, tous solubles dans l'eau.

2. Solution de conservation selon la revendication 1, caractérisée en ce que l'absorption de la lumière du composé ajouté est située dans une gamme de 300 à 450 nm.

3. Solution de conversation selon la revendication 1, caractérisée en ce qu'elle contient de 0,1 à 10 % en poids du composé absorbant la lumière.

4. Solution de conversation selon la revendication 1, caractérisée en ce qu'elle contient en outre un acide à action hydrophile.

5. Solution de conversation selon la revendication 1, caractérisée en ce qu'elle contient comme composé organique macromoléculaire, filmogène, soluble dans l'eau, de la gomme arabique, de la dextrine, un alcool polyvinylique ou un polymère d'acrylamide soluble dans l'eau.

6. Procédé pour la conservation des formes pour impression à plat, prêtes à l'emploi, contenant des composés diazoïques durcis à la lumière, dans lequel la forme pour impression à plat est traitée avec une solution aqueuse d'un composé organique, macromoléculaire, filmogène, soluble dans l'eau, et puis est séchée, procédé caractérisé en ce que l'on utilise une solution qui contient en outre un composé montrant une forte absorption de la lumière dans le domaine spectral dans lequel la photolyse des composés diazoïques aromatiques photosensibles est initiée et qui appartient au groupe des dérivés de pyrazoline, des dérivés de 6-phényl-α-pyrone, des dérivés de quinoléine, des hétérocyles substitués et des 2,4-dinitrodiphénylaminocarboxylates, tous solubles dans l'eau.